# EUROPEAN PATENT APPLICATION

(11) **EP 4 770 389 A1**
(43) Date of publication of application: **01.07.2026**
(21) Application number: 25214867.1
(22) Date of filing: 11.11.2025
(51) Int. Cl.: H10K 59/40, H10K 59/50, H10K 59/80

(54) **LIGHT EMITTING DIODE DISPLAY DEVICE**

(30) Priority: 27.12.2024 KR 20240198585
(71) Applicant: LG Display Co., Ltd., Seoul, 07336 (KR)
(72) Inventor: LEE, Dae-Heung, 10845 Paju-si, Gyeonggi-do (KR)
(74) Representative: Viering, Jentschura & Partner mbB Patent- und Rechtsanwälte

(57) **Abstract**

A light emitting diode display device (100, 300, 400, 500) includes: a display panel (101); first, second and third pixel regions (P1, P2, P3); a light emitting diode (D) in each of a first emission area (EA1) of the first pixel region (P1), a second emission area (EA2) of the second pixel region (P2) and a third emission area (EA3) of the third pixel region (P3); a transmittance variable layer (120) disposed on the display panel (101) and in each emission area; a touch electrode layer (111) disposed at one side of the transmittance variable layer (120) and including first and second touch electrodes (112, 113), wherein the first touch electrode (112) is disposed in each emission area, and the second touch electrode (113) is disposed in each of a first non-emission area (NEA1) and a second non-emission area (NEA2); and a driving electrode (132) disposed at the other one side of the transmittance variable layer (120) and corresponding to the first touch electrode (112).

## Description

### BACKGROUND

### 1. Technical Field

The present disclosure relates to a light emitting diode display device, and more specifically, for example, without limitation, to a light emitting diode display device being capable of minimizing or preventing an ambient light reflection without brightness degradation.

### 2. Description of Related Art

As the large-area display device is developed, the demand for the flat display device with small space occupancy is increasing. As one type of the flat display device, the technology of an organic light emitting display device including an organic light emitting diode (OLED) and an inorganic light emitting display device including an inorganic light emitting diode is developing rapidly.

For example, in the organic light emitting display device, holes from an anode and electrons from a cathode are combined to generate an exciton in an organic light emitting layer, and the exciton is transformed from an excited state to a ground state. As a result, the light is emitted from the OLED.

Unlike a liquid crystal display device, the light emitting diode display device may not require a polarizer. However, in the organic light emitting display device without a polarizer, a problem of display quality degradation due to an ambient (or external) light reflection occurs. Therefore, in order to minimize or reduce ambient light reflection, the organic light emitting display device may include a polarizer on the display surface.

In the organic light emitting display device with the polarizer, the ambient light reflection can be minimized or reduced, but a problem of brightness degradation occurs due to the polarizer.

The description of related art should not be considered prior art merely because it is mentioned in or associated with this section. The description of related art includes information that describes one or more aspects of the subject technology, and the description in this section does not limit the scope of the invention.

### SUMMARY

One or more aspects of the present disclosure are directed to a light emitting diode display device that substantially obviates one or more of the problems associated with the limitations and disadvantages of the related conventional art.

An aspect of the present disclosure is to provide a light emitting diode display device being capable of minimizing or preventing an ambient light reflection without brightness degradation.

Additional features and advantages of the present disclosure are set forth in the description which follows, and will be apparent from the description, or evident by practice of the present disclosure. The aspects and other advantages of the present disclosure are realized and attained by the features described herein as well as in the appended drawings. According to an aspect of the present disclosure, a light emitting diode display device according to claim 1 is provided. Further embodiments are described in the dependent claims.

To achieve the aforementioned and other advantages in accordance with the purpose of the embodiments of the present disclosure, as described herein, an aspect of the present disclosure is a light emitting diode display device comprising a display panel including first, second and third pixel regions and a light emitting diode in each of a first emission area of the first pixel region, a second emission area of the second pixel region and a third emission area of the third pixel region; a transmittance variable layer disposed on the display panel and in each of the first to third emission areas; a touch electrode layer disposed at one side of the transmittance variable layer and including a first touch electrode and a second touch electrode, wherein the first touch electrode is disposed in each of the first to third emission areas, and the second touch electrode is disposed in each of a first non-emission area between the first and second emission areas and a second non-emission area between the second and third emission areas; and a driving electrode disposed at the other one side of the transmittance variable layer and corresponding to the first touch electrode.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with embodiments of the disclosure.

It is to be understood that both the foregoing general description and the following detailed description are examples and explanatory and are intended to further explain the present disclosure as claimed.

### BRIEF DESCRIPTION OF THE DRAWINGS

The accompanying drawings, which are included to provide a further understanding of the present disclosure and are incorporated in and constitute a part of this specification, illustrate embodiments of the present disclosure and together with the description serve to explain the principles of the present disclosure.
FIG. 1 is a schematic circuit diagram of a light emitting diode display device according to an embodiment of the present disclosure.
FIGs. 2A and 2B are schematic plane views illustrating a light emitting diode display device according to a first embodiment of the present disclosure.
FIGs. 3A and 3B are schematic cross-section views illustrating the light emitting diode display device according to the first embodiment of the present disclosure.
FIG. 4 is a schematic cross-section view of a display panel of the light emitting diode display device according to the first embodiment of the present disclosure.
FIG. 5 is a schematic cross-section view of an organic light emitting display device according to a second embodiment of the present disclosure.
FIG. 6 is a schematic cross-section view of an organic light emitting display device according to a third embodiment of the present disclosure.
FIG. 7 is a schematic cross-section view of an organic light emitting display device according to a fourth embodiment of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to aspects of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present disclosure and methods of achieving them will be apparent with reference to the aspects described below in detail with the accompanying drawings. However, the present disclosure is not limited to the aspects disclosed below, but can be realized in a variety of different forms, and only these aspects allow the disclosure of the present disclosure to be complete. The present disclosure is provided to fully inform the scope of the disclosure to the skilled in the art of the present disclosure.

The shapes, sizes, proportions, angles, numbers, and the like disclosed in the drawings for explaining the aspects of the present disclosure are illustrative, and the present disclosure is not limited to the illustrated matters. The same reference numerals refer to the same elements throughout the specification. In addition, in describing the present disclosure, if it is determined that a detailed description of the related known technology unnecessarily obscure the subject matter of the present disclosure, the detailed description thereof can be omitted. When 'including,' 'having,' 'consisting,' and the like are used in this specification, other parts may be added unless 'only' is used. When a component is expressed in the singular, cases including the plural are included unless specific statement is described.

The expression "at least one of a, b, and c" described throughout the specification can encompass 'a alone,' 'b alone,' 'c alone,' 'a and b,' 'a and c,' 'b and c,' or 'all of a, b, and c.' The advantages and features of the present disclosure, and the methods for achieving them, will become apparent by referring to the embodiments described in detail below together with the accompanying drawings.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

The area, length, or thickness of each component described in the specification is illustrated for convenience of explanation, and the present disclosure is not necessarily limited to the area and thickness of the illustrated component.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Rather, these embodiments may be provided so that this disclosure may be sufficiently thorough and complete to assist those skilled in the art to fully understand the scope of the present disclosure. Furthermore, the present disclosure is only defined by scopes of claims.

Features of various aspects of the present disclosure may be partially or overall coupled to or combined with each other, and may be variously inter-operated with each other and driven technically as those skilled in the art can sufficiently understand. The aspects of the present disclosure may be carried out independently from each other, or may be carried out together in co-dependent relationship.

Without specific description, a transistor constituting the pixel circuit of the present disclosure may include at least one of an oxide thin film transistor (Oxide TFT), an amorphous silicon TFT (a-Si TFT), and a low temperature poly silicon (LTPS) TFT.

The following embodiments are described with reference to organic light emitting diode display devices. However, the embodiment of the present disclosure is not limited to organic light emitting diode display devices. For example, a display device according to an embodiment of the present disclosure may be an organic light emitting diode display device using an organic light emitting material or an inorganic light emitting diode display device using an inorganic light emitting material such as a quantum dot. Namely, the light emitting diode display device of the present disclosure may be an organic light emitting diode display device or an inorganic light emitting diode display device.

Reference will now be made in detail to some of the example embodiments, which are illustrated in the accompanying drawings.

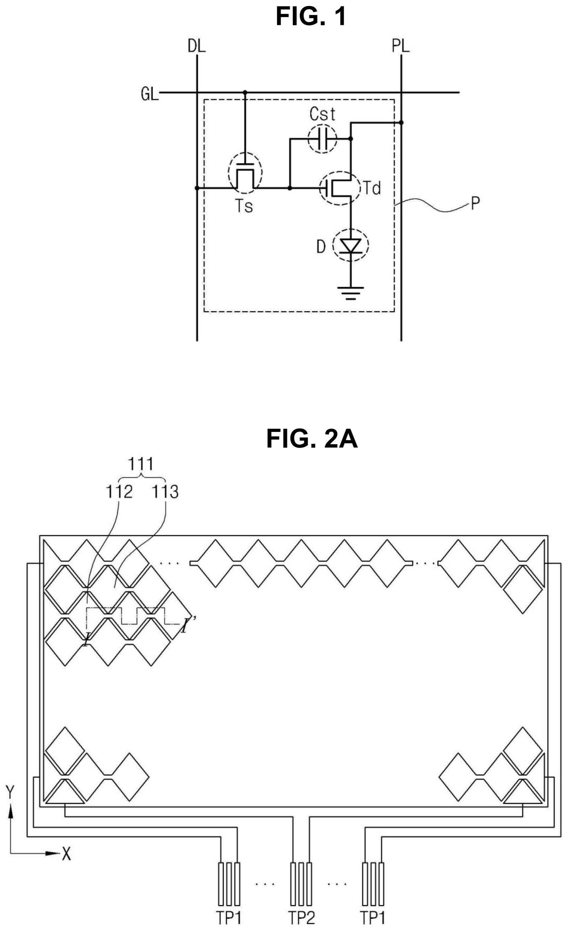

FIG. 1 is a schematic circuit diagram of an organic light emitting diode display device according to an embodiment of the present disclosure.

As shown in FIG. 1, an organic light emitting display device includes a gate line GL, a data line DL and a power line PL. The gate line GL, the data line DL and the power line PL cross each other to define a pixel region P. In the pixel region P, a switching thin film transistor TFT Ts, a driving TFT Td, a storage capacitor Cst and an OLED D are disposed. The pixel region may include a red pixel region, a green pixel region and a blue pixel region.

The switching TFT Ts is connected to the gate line GL and the data line DL, and the driving TFT Td and the storage capacitor Cst are connected to the switching TFT Ts and the power line PL. The OLED D is connected to the driving TFT Td.

In the organic light emitting display device, when the switching TFT Ts is turned on by a gate signal applied through the gate line GL, a data signal from the data line DL is applied to the gate electrode of the driving TFT Td and an electrode of the storage capacitor Cst.

When the driving TFT Td is turned on by the data signal, an electric current is supplied to the OLED D from the power line PL. As a result, the OLED D emits light. In this case, when the driving TFT Td is turned on, a level of an electric current applied from the power line PL to the OLED D is determined such that the OLED D can produce a gray scale.

The storage capacitor Cst serves to maintain the voltage of the gate electrode of the driving TFT Td when the switching TFT Ts is turned off.

Accordingly, even if the switching TFT Ts is turned off, a level of an electric current applied from the power line PL to the OLED D is maintained to next frame. As a result, the organic light emitting display device displays a desired image.

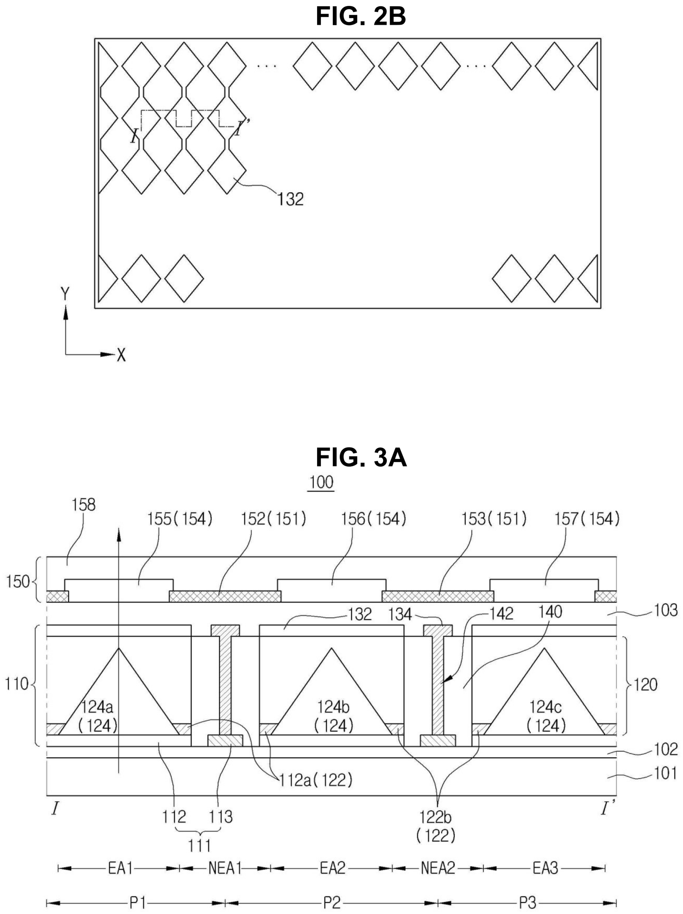

FIGs. 2A and 2B are schematic plane views illustrating a light emitting diode display device according to a first embodiment of the present disclosure. In more detail, FIG. 2A is a schematic plane view showing a touch electrode layer of a transmittance variable touch panel, and FIG. 2B is a schematic plane view showing a driving electrode layer of the transmittance variable touch panel.

The light emitting diode display device of the present disclosure includes a display panel including a light emitting diode and a transmittance variable touch panel disposed over the display panel. The transmittance variable touch panel includes a transmittance variable layer, a touch electrode layer at one side of the transmittance variable layer and a plurality of driving electrodes at the other one side of the transmittance variable layer.

As shown in FIG. 2A, the touch electrode layer 111 includes a first touch electrode row including a plurality of first touch electrodes 112 and a second touch electrode row including a second touch electrodes 113. The first touch electrodes 112 are arranged along a first direction X. The second touch electrode row is spaced apart from the first touch electrode row along a second direction Y, and the second touch electrodes 113 are arranged along the first direction X. The first and second directions X and Y may be perpendicular to each other. The touch electrode layer 111 may be disposed on a first buffer layer 102 (of FIG. 3A).

The first touch electrodes 112 in the first touch electrode row are connected to each other, and the second touch electrodes 113 in the second touch electrode row are connected to each other.

Each of a plurality of first touch electrode rows is connected to a first touch electrode pad TP1 through a connection line at an end of the first direction X. The second touch electrodes 113 in each of the second touch electrode rows are connected through a bridge electrode and are connected to a second touch electrode pad TP2 through a connection line at an end of the second direction Y.

As shown in FIG. 2B, the plurality of driving electrodes 132 are arranged along the first direction X and the second direction Y. The plurality of driving electrodes 132 arranged along the second direction Y is connected to each other by a connection part. The plurality of driving electrodes 132 arranged along the first and second directions X and Y are connected to a driving electrode pad (not shown). The driving electrode 132 is disposed on the transmittance variable layer 120 (of FIG. 3A).

The first touch electrode 112 corresponds to and overlaps the driving electrode 132. For example, the driving electrode 132 is positioned over the first touch electrode 112 and may have a width (or an area) being same as the first touch electrode 112.

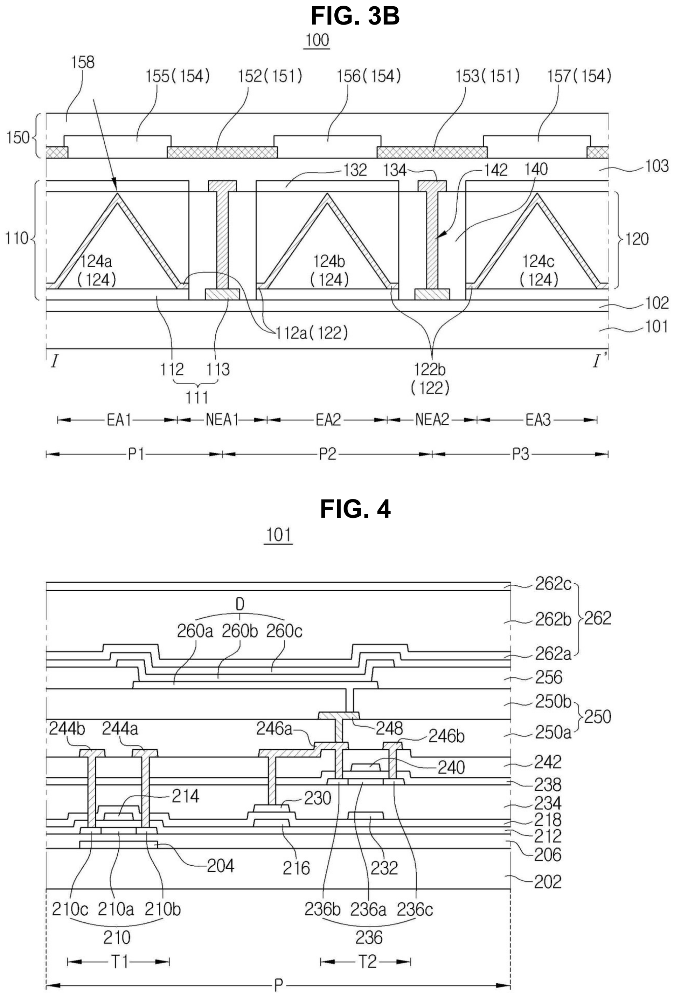

FIGs. 3A and 3B are schematic cross-section views illustrating the light emitting diode display device according to the first embodiment of the present disclosure. In more detail, FIGs. 3A and 3B are schematic cross-section views taken along the line I-I' of FIG. 2A or FIG. 2B and respectively shows an on state and an off state of the light emitting diode display device.

As shown in FIGs. 3A and 3B, the light emitting diode display device 100 includes a display panel 101 and a transmittance variable touch panel 110 disposed over the display panel 101.

In addition, the light emitting diode display device 100 may further include a color filter panel 150 disposed over the transmittance variable touch panel 110. Namely, the transmittance variable touch panel 110 may be positioned between the display panel 101 and the color filer panel 150.

Moreover, the light emitting diode display device 100 may further include at least one of a first buffer layer 102 between the display panel 101 and the transmittance variable touch panel 110 and a second buffer layer 103 between the transmittance variable touch panel 110 and the color filter panel 150. Each of the first and second buffer layers 102 and 103 may be formed of an inorganic insulating material, e.g., silicon oxide or silicon nitride, or an organic insulating material, e.g., photo-aryl or benzocyclobutene, and may have a single-layered structure or a multi-layered structure.

The display panel 101 may be an organic light emitting diode display panel or an inorganic light emitting diode display panel.

Referring to FIG. 4, which is a schematic cross-section view of a display panel of the light emitting diode display device according to the first embodiment of the present disclosure, the display panel 101 includes a substrate 202 including a pixel region P and a light emitting diode D corresponding to the pixel region P and disposed over the substrate 202.

The pixel region P may include first, second and third pixel regions P1, P2 and P3. The first pixel region P1 may be a red pixel region, the second pixel region P2 may be a green pixel region and a third pixel region P3 may be a blue pixel region.

Each of the first to third pixel regions P1, P2 and P3 may include an emission area and a non-emission area. For example, a first emission area EA1 of the first pixel region P1, a second emission area EA2 of the second pixel region P2, a third emission area EA of the third pixel region P3, a first non-emission area NEA1 between the first and second emission areas EA1 and EA2, a second non-emission area NEA2 between the second and third emission areas EA2 and EA3 and a third non-emission area between the first and third emission areas EA1 and EA3 may be defined on the substrate 202.

The substrate 202 may be a glass substrate or a plastic substrate. For example, the substrate 202 may be one of polyimide (PI) substrate, polyethersulfone (PES) substrate, polyethylenenaphthalate (PEN) substrate, polyethylene terephthalate (PET) substrate and polycarbonate (PC) substrate.

In an example embodiment of the present disclosure, the substrate may have a triple-layered structure including a first polyimide layer, a second polyimide layer and an interlayer inorganic layer between the first and second polyimide layers. The interlayer inorganic layer may be formed of an inorganic insulating material, e.g., silicon oxide or silicon nitride.

A first light shielding pattern 204 is disposed on the substrate 202. The light through the substrate 202 can be blocked by the first light shielding pattern 204. For example, the first light shielding pattern 204 may be formed of a metallic material, e.g., molybdenum (Mo), aluminum (Al), chromium (Cr), gold (Au), titanium (Ti), nickel (Ni), neodymium (Nd), copper (Cu) or their alloy, and have a single-layered structure or a multi-layered structure.

A buffer layer, which is formed of an inorganic insulating material, e.g., silicon oxide or silicon nitride, may be disposed between the substrate 202 and the first light shielding pattern 204.

A third buffer layer 206 covering the first light shielding pattern 204 is disposed over the substrate 202. The moisture and/or oxygen can be blocked by the third buffer layer 206. For example, the third buffer layer 206 may be formed of an inorganic insulating material, e.g., silicon oxide or silicon nitride, and have a single-layered structure or a multi-layered structure. When the first light shielding pattern 204 is omitted, the third buffer layer 206 may be directly formed on the substrate 202 and contact the substrate 202.

A first semiconductor layer 210 corresponding to the first light shielding pattern 204 is disposed on the third buffer layer 206. The first semiconductor layer 210 may include one of a poly-semiconductor material, an amorphous semiconductor material and an oxide semiconductor material. When the first light shielding pattern 204 and the third buffer layer 206 are omitted, the first semiconductor layer 210 may be directly disposed on the substrate 202.

In an example embodiment of the present disclosure, the first semiconductor layer 210 may be formed of a poly-semiconductor material, e.g., polycrystalline silicon. The first semiconductor layer 210 may include a first channel region 210a, a first source region 210b at one side of the first channel region 210a and a first drain region 210c at the other side of the first channel region 210a. Impurities may be dopped into the first source and drain regions 210b and 210c.

A first gate insulating layer 212 covering the first semiconductor layer 210 is disposed over the third buffer layer 206. The first gate insulating layer 212 may be formed of an inorganic insulating material, e.g., silicon oxide or silicon nitride, and have a single-layered structure or a multi-layered structure.

A first gate electrode 214 corresponding to the first channel region 210a of the first semiconductor layer 210 is disposed on the first gate insulating layer 212. In addition, a first capacitor electrode 216, which is spaced apart from the first gate electrode 214, is disposed on the first gate insulating layer 212.

The first gate electrode 214 and the first capacitor electrode 216 may be disposed on the same layer and be formed of the same material. For example, each of the first gate electrode 214 and the first capacitor electrode 216 may be formed of a metallic material, e.g., Mo, Al, Cr, Au, Ti, Ni, Nd, Cu or their alloy, and have a single-layered structure or a multi-layered structure.

A first interlayer insulating layer 218 covering the first gate electrode 214 and the first capacitor electrode 216 is disposed on the first gate insulating layer 212. The first interlayer insulating layer 218 may be formed of an inorganic insulating material, e.g., silicon oxide or silicon nitride, and have a single-layered structure or a multi-layered structure.

A second capacitor electrode 230 corresponding to the first capacitor electrode 216 and a second light shielding pattern 232 spaced apart from the second capacitor electrode 230 are disposed on the first interlayer insulating layer 218.

The second capacitor electrode 230 and the second light shielding pattern 232 may be disposed on the same layer and be formed of the same material. For example, each of the second capacitor electrode 230 and the second light shielding pattern 232 may be formed of a metallic material, e.g., Mo, Al, Cr, Au, Ti, Ni, Nd, Cu or their alloy, and have a single-layered structure or a multi-layered structure.

A second interlayer insulating layer 234 covering the first second capacitor electrode 230 and the second light shielding pattern 232 is disposed on the first interlayer insulating layer 218. The external moisture and/or oxygen can be blocked by the second interlayer insulating layer 234. For example, the second interlayer insulating layer 234 may be formed of an inorganic insulating material, e.g., silicon oxide or silicon nitride, or an organic insulating material, e.g., photo-acryl or benzocyclobutene (BCB), and have a single-layered structure or a multi-layered structure.

A second semiconductor layer 236 corresponding to the second light shielding pattern 232 is disposed on the second interlayer insulating layer 234. The second semiconductor layer 236 may include one of a poly-semiconductor material, an amorphous semiconductor material and an oxide semiconductor material.

In an example embodiment of the present disclosure, the second semiconductor layer 236 may be formed of an oxide semiconductor material, e.g., indium-gallium-zinc oxide (IGZO), zinc oxide (ZnO), tin oxide (SnO2), copper oxide (Cu2O), nickel oxide (NiO), indium-tin-zinc oxide (ITZO) or indium-aluminum-zinc oxide (IAZO).

The second semiconductor layer 236 may include a second channel region 236a, a second source region 236b at one side of the second channel region 236a and a second drain region 236c at the other side of the second channel region 236a. Impurities may be dopped into the second source and drain regions 236b and 236c.

A second gate insulating layer 238 covering the second semiconductor layer 236 is disposed over the second interlayer insulating layer 234. The second gate insulating layer 238 may be formed of an inorganic insulating material, e.g., silicon oxide or silicon nitride, and have a single-layered structure or a multi-layered structure.

A second gate electrode 240 corresponding to the second channel region 236a of the second semiconductor layer 236 is disposed on the second gate insulating layer 238. For example, the second gate electrode 240 may be formed of a metallic material, e.g., Mo, Al, Cr, Au, Ti, Ni, Nd, Cu or their alloy, and have a single-layered structure or a multi-layered structure.

A third interlayer insulating layer 242 covering the second gate electrode 240 is disposed on the second gate insulating layer 238. The third interlayer insulating layer 242 may be formed of an inorganic insulating material, e.g., silicon oxide or silicon nitride, and have a single-layered structure or a multi-layered structure.

A first source electrode 244a, a first drain electrode 244b, a second source electrode 246a and a second drain electrode 246b are disposed on the third interlayer insulating layer 242.

The first source electrode 244a and the first drain electrode 244b are respectively connected to the first source region 210b and the first drain region 210c via contact holes through the third interlayer insulating layer 242, the second gate insulating layer 238, the second interlayer insulating layer 234, the first interlayer insulating layer 218 and the first gate insulating layer 212. The first source electrode 244a is connected to the first capacitor electrode 216 via a contact hole through the third interlayer insulating layer 242, the second gate insulating layer 238, the second interlayer insulating layer 234 and the first interlayer insulating layer 218.

The second source electrode 246a and the second drain electrode 246b are respectively connected to the second source region 236b and the second drain region 236c via contact holes through the third interlayer insulating layer 242 and the second gate insulating layer 238. The second source electrode 246a is connected to the second capacitor electrode 230 via a contact hole through the third interlayer insulating layer 242, the second gate insulating layer 238 and the second interlayer insulating layer 234.

The first source and drain electrodes 244a and 244b and the second source and drain electrodes 246a and 246b may be disposed on the same layer and formed of the same material. For example, each of the first source and drain electrodes 244a and 244b and the second source and drain electrodes 246a and 246b may be formed of a metallic material, e.g., Mo, Al, Cr, Au, Ti, Ni, Nd, Cu or their alloy, and have a single-layered structure or a multi-layered structure.

The first semiconductor layer 210, the first gate electrode 214, the first source electrode 244a and the first drain electrode 244b constitute a first TFT T1, and the second semiconductor layer 236, the second gate electrode 240, the second source electrode 246a and the second drain electrode 246b constitute a second TFT T2. For example, the first TFT T1 may be a switching TFT, and the second TFT may be a driving TFT. In addition, the first and second capacitor electrodes 216 and 230 constitute a storage capacitor.

The display panel 101 of the present disclosure includes the first and second TFTs T1 and T2. Each of the first semiconductor layer 210 of the first TFT T1 and the second semiconductor layer 236 of the second TFT T2 may include one of a poly-semiconductor material, an amorphous semiconductor material and an oxide semiconductor material, and at least one of the first semiconductor layer 210 of the first TFT T1 and the second semiconductor layer 236 of the second TFT T2 may include the oxide semiconductor material. In an example embodiment of the present disclosure, the first semiconductor layer 210 of the first TFT T1 may be formed of the poly-semiconductor material, e.g., polycrystalline silicon, and the second semiconductor layer 236 of the second TFT T2 may be formed of the oxide semiconductor material.

In FIG. 4, the first gate electrode 214, the first source electrode 244a and first drain electrode 246a are disposed over the first semiconductor layer 210, and the second gate electrode 240, the second source electrode 246a and the second drain electrode 246b are disposed over the second semiconductor layer 236. Namely, each of the first and second TFTs T1 and T2 has a coplanar structure. Alternatively, in each of the first and second TFTs T1 and T2, a gate electrode may be disposed under a semiconductor layer, and a source and a drain electrode may be disposed over the semiconductor layer. Namely, each of the TFTs T1 and T2 may have an inverted-staggered structure.

A first planarization layer 250 covering the first source and drain electrodes 244a and 244b and the second source and drain electrodes 246a and 246b is disposed on the third interlayer insulating layer 242.

The first planarization layer 250 may be formed of an organic insulating material, e.g., photo-aryl or BCB.

The first planarization layer 250 may include a first planarization layer 250a on the first source and drain electrodes 244a and 244b and the second source and drain electrodes 246a and 246b and a second planarization layer 250b on the first planarization layer 250a.

A connection electrode 248 corresponding to the second source electrode 246a is disposed on the first planarization layer 250a. The connection electrode 248 may connected to the second source electrode 246a through a contact hole in the first planarization layer 250a. For example, the connection electrode 248 may be formed of a metallic material, e.g., Mo, Al, Cr, Au, Ti, Ni, Nd, Cu or their alloy, and have a single-layered structure or a multi-layered structure.

The second planarization layer 250b is disposed on the first planarization layer 250a to cover the connection electrode 248, and a first electrode 260a is disposed on the second planarization layer 250b. The first electrode 260a corresponds to the connection electrode 248 and is connected to the connection electrode 248 through a contact hole in the second planarization layer 250b.

For example, the first electrode 260a is separately formed in each pixel region P. The first electrode 260a may be an anode and may include a transparent conductive oxide (TCO) layer, which is formed of a conductive material, e.g., a transparent conductive oxide material, having a relatively high work function, and a reflective layer.

For example, the transparent conductive oxide material may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO), and the reflective layer may include at least one of silver (Ag), an alloy of Ag and one of palladium (Pd), Cu, In and Nd and aluminum-palladium-copper alloy (APC). For example, the first electrode 260a may have a double-layered structure of Ag/ITO or APC/ITO or a triple-layered structure of ITO/Ag/ITO or ITO/APC/ITO.

A bank 256 is formed on the second planarization layer 250b at a boundary of the pixel region. The bank 256 covers an edge of the first electrode 260a and has a first opening to expose a center of the first electrode 260a. The bank 256 may extend into a portion of the non-display area NDA. The bank 256 may include a light-absorbing particle, e.g., a black particle, to have a light-absorbing property.

A spacer is disposed on the bank 256. For example, each of the bank 256 and the spacer may include an organic insulating material, e.g., photo-acryl, benzocyclobutene (BCB) or polyimide.

A light emitting layer 260b covering the first electrode 260a and the bank 256 is disposed. The light emitting layer 260b contacts the first electrode 260a in the first opening of the bank 256. Namely, the light emitting layer 260b may be formed to contact an upper surface of the first electrode 260a and a side surface and an upper surface of the bank 256.

For example, the light emitting layer 260b may include an organic emitting material layer (EML) including a host and a dopant or an inorganic emitting material layer including a quantum dot. In addition, the light emitting layer 260b may further include at least one of a hole injection layer (HIL), a hole transporting layer (HTL), an electron blocking layer (EBL), a hole blocking layer (HBL), an electron transporting layer (ETL) and an electron injection layer (EIL) to have a multi-layered structure.

A second electrode 260c is formed over the substrate 202 where the organic emitting layer 260b is formed. The second electrode 260c covers an entire surface of the display area. The second electrode 260c may be formed of at least one of ITO, IZO, Al, Ag, Cu, Pb, magnesium (Mg), Mo, Ti and their alloy and have a single-layered structure or a multi-layered structure. The second electrode 260c may have a thin profile (small thickness) to provide a light transmittance property (or a semi-transmittance property).

The first electrode 260a, the light emitting layer 260b and the second electrode 260c constitute a light emitting diode D. The light emitting diode D may emit the red, green and blue light in the red, green and blue pixel region, respectively.

In the display panel 101, the light from the light emitting layer 260b passes through the second electrode 260c to display an image. Namely, the organic light emitting display panel 101 of the present disclosure is a top-emission type display panel.

An encapsulation layer (or encapsulation film) 262 is formed on the second electrode 260c to prevent or reduce penetration of moisture into the light emitting diode D. The encapsulation layer 262 may cover an entire substrate 202. The encapsulation layer 262 includes a first inorganic insulating layer 262a, an organic insulating layer 262b and a second inorganic insulating layer 262c sequentially stacked, but it is not limited thereto.

Each of the first and second inorganic insulating layers 262a and 262c may be formed of an inorganic insulating material, e.g., silicon oxide or silicon nitride. The organic insulating layer 262b may be formed of an organic insulating material, e.g., acryl resin, epoxy resin, phenolic resin, polyamide resin or polyimide resin.

Referring again to FIGs. 3A and 3B, the first buffer layer 102 is disposed on the display panel 101, and the transmittance variable touch panel 110 is disposed on the first buffer layer 102.

The transmittance variable touch panel 110 includes a transmittance variable layer 120, a driving electrode 132 and a touch electrode layer 111.

The transmittance variable layer 120 may positioned in each of the first, second and third pixel regions P1, P2 and P3 and may include a spacer 124 and a light absorbing layer 122.

The spacer 124 includes a first spacer 124a in the first emission area EA1, a second spacer 124b in the second emission area EA2 and a third spacer 124c in the third emission area EA3. The first to third spacers 124a, 124b and 124c are spaced apart from each other. A space between the first and second spacers 124a and 124b may correspond to the first non-emission area NEA1, and a spacer between the second and third spacers 124b and 124c may correspond to the second emission area NEA2. A spacer between the first and third spacers 124a and 124c may correspond to the third non-emission area.

Each of the first to third spacers 124a, 124b and 124c has a lower portion having a first width and an upper portion having a second width. The second width is smaller than the first width. For example, each of the first to third spacers 124a, 124b and 124c may have a triangular cone shape.

Each of the first to third spacers 124a, 124b and 124c may be formed of an organic insulating material, e.g., acryl resin, epoxy resin, phenolic resin, polyamide resin or polyimide resin.

The light absorbing layer 122 is disposed in a space between adjacent two of the first to third spacers 124a, 124b and 124c or at a side surface of each of the first to third spacers 124a, 124b and 124c. Namely, the light absorbing layer 122 is positioned in the first non-emission area NEA1, the second non-emission area NEA2 and the third non-emission area or covers the side surface of each of the first to third spacers 124a, 124b and 124c.

The light absorbing layer 122 includes a charged black particle. The light absorbing layer 122 is positioned in the emission areas EA1, EA2 and EA3 or the non-emission areas NEA1 and NEA2 according to the operation (or drive) of the transmittance variable touch panel 110 so that the transmittance of the transmittance variable touch panel 110 and the light emitting diode display device 100 can be controlled.

The light absorbing layer 122 may include a first light absorbing layer 122a positioned in the first non-emission area NEA1 or one side surface of the first spacer 124a and one side surface of the second spacer 124b and a second light absorbing layer 122b positioned in the second non-emission area NEA2 or one side surface of the second spacer 124b and one side surface of the third spacer 124c.

The touch electrode layer 111 is positioned at one side of the transmittance variable layer 120. For example, the touch electrode layer 111 may be positioned on the first buffer layer 102 and under the transmittance variable layer 120.

The touch electrode layer 111 may include a first touch electrode 112 positioned in the first to third emission areas EA1, EA2 and EA3 and a second touch electrode 113 positioned in the first and second non-emission areas NEA1 and NEA2.

Each of the first and second touch electrodes 112 and 113 is formed of a conductive material. For example, each of the first and second touch electrodes 112 and 113 may be formed of at least one of molybdenum (Mo), aluminum (Al), chromium (Cr), gold (Au), titanium (Ti), nickel (Ni), neodymium (Nd), copper (Cu), indium-tin-oxide (ITO), indium-zinc-oxide (IZO), indium-tin-zinc oxide (ITZO), tin oxide (SnO), zinc oxide (ZnO), indium-copper-oxide (ICO), and aluminum:zinc oxide (Al:ZnO; AZO).

In the first emission area EA1, a center of the first touch electrode 112 is positioned in the first emission area EA1, both ends of the first touch electrode 112 extends into a portion of the first non-emission area NEA1 and a third non-emission area between the first and third emission areas EA1 and EA3. In the second emission area EA2, a center of the first touch electrode 112 is positioned in the second emission area EA2, both ends of the first touch electrode 112 extends into a portion of the first and second non-emission areas NEA1 and NEA2. In the third emission area EA3, a center of the first touch electrode 112 is positioned in the third emission area EA3, both ends of the first touch electrode 112 extends into a portion of the second non-emission area NEA2 and the third non-emission area. Namely, an area of the first touch electrode 112 in each of the first to third emission areas EA1, EA2 and EA3 may be greater than that of the first to third emission areas EA1, EA2 and EA3.

The second touch electrode 113 is spaced apart from the first touch electrode 112 and is positioned in a portion of each of the first to third emission areas EA1, EA2 and EA3. Namely, an area of the second touch electrode 113 in each of the first to third emission areas EA1, EA2 and EA3 may be smaller than that of the first to third emission areas EA1, EA2 and EA3.

The driving electrode 132 is positioned at the other one side of the transmittance variable layer 120. For example, the driving electrode 132 may be positioned at a n upper side of the transmittance variable layer 120.

The driving electrode 132 is formed of a conductive material. For example, each of the first and second touch electrodes 112 and 113 may be formed of at least one of molybdenum (Mo), aluminum (Al), chromium (Cr), gold (Au), titanium (Ti), nickel (Ni), neodymium (Nd), copper (Cu), indium-tin-oxide (ITO), indium-zinc-oxide (IZO), indium-tin-zinc oxide (ITZO), tin oxide (SnO), zinc oxide (ZnO), indium-copper-oxide (ICO), and aluminum:zinc oxide (Al:ZnO; AZO).

The driving electrode 132 is positioned in the first to third emission areas EA1, EA2 and EA3. Namely, in the first to third emission areas EA1, EA2 and EA3, the driving electrode 132 overlaps the first touch electrode 112 with the spacer 124 and the light absorbing layer 122 therebetween.

In the first to third emission areas EA1, EA2 and EA3, an area of the driving electrode 132 may be equal to that of the first touch electrode 112.

The transmittance variable touch panel 110 may further include a partition wall 140 positioned in each of the first and second non-emission areas NEA1 and NEA2. The partition wall 140 may be further positioned in the third non-emission area. The partition wall 140 may cover the second touch electrode 113 and have an area greater than the second touch electrode 113.

The partition wall 140 may be formed of an organic material, e.g., acryl resin, epoxy resin, phenolic resin, polyamide resin or polyimide resin. The partition wall 140 may be disposed on the same layer and formed of the same material as the spacer 124.

The transmittance variable touch panel 110 may further include a bridge electrode 134 on the partition wall 140. The bridge electrode 134 may be connected to the second touch electrode 113 through a contact hole 142 formed in the partition wall 140.

The bridge electrode 134 may be formed of a conductive material. For example, the bridge electrode 134 may be formed of at least one of molybdenum (Mo), aluminum (Al), chromium (Cr), gold (Au), titanium (Ti), nickel (Ni), neodymium (Nd), copper (Cu), indium-tin-oxide (ITO), indium-zinc-oxide (IZO), indium-tin-zinc oxide (ITZO), tin oxide (SnO), zinc oxide (ZnO), indium-copper-oxide (ICO), and aluminum:zinc oxide (Al:ZnO; AZO).

Referring to FIGs. 3A and 4, in a first driving mode, in which the light emitting diode D is on, no voltage difference occurs between the driving electrode 132 and the first touch electrode 112 so that the light absorption layer 122 can be positioned in the space between adjacent two of the first to third spacers 124a, 124b and 124c, i.e., the first non-emission area NEA1, the second non-emission area NEA2 and the third non-emission area.

In other words, the first light absorbing layer 122a may be positioned on an edge of the first touch electrode 112 in the first non-emission area NEA1, and the second light absorbing layer 122b may be positioned on an edge of the first touch electrode 112 in the second non-emission area NEA2.

As a result, in the first driving mode, the transmittance variable touch panel 110 or the light emitting diode display device 100 has a relatively high transmittance in each of the first to third emission areas EA1, EA2 and EA3. Accordingly, the light from the light emitting diode D of the display panel 101 can be displayed in the first to third emission areas EA1, EA2 and EA3 without brightness degradation.

Referring to FIGs. 3B and 4, in a second driving mode, in which the light emitting diode D is off, a voltage difference occurs between the driving electrode 132 and the first touch electrode 112 so that the light absorption layer 122 can cover the side surface of the first to third spacers 124a, 124b and 124c. Namely, in the second driving mode, the light absorbing layer 122 may be positioned in the first to third emission areas EA1, EA2 and EA3.

In other words, the first light absorbing layer 122a may cover one side surface of the first spacer 124a and one side surface of the second spacer 124b, and the second light absorbing layer 122b may cover the other side surface of the second spacer 124b and one side surface of the third spacer 124c.

As a result, in the first driving mode, the transmittance variable touch panel 110 or the light emitting diode display device 100 has a relatively low transmittance in each of the first to third emission areas EA1, EA2 and EA3. Accordingly, the ambient light reflection in the light emitting diode display device 100 can be minimized or reduced.

Namely, in the first driving mode, the light absorbing layer 122 is positioned in the first and second non-emission areas NEA1 and NEA2 so that the transmittance variable layer 120 may have a first transmittance in each of the first to third emission areas EA1, EA2 and EA3. In the second driving mode, the light absorbing layer 122 covers the side surface of the first to third spacers 124a, 124b and 124c so that the transmittance variable layer 120 may have a second transmittance, which is smaller than the first transmittance, in each of the first to third emission areas EA1, EA2 and EA3.

In an example embodiment of the present disclosure, in the second driving mode, the light absorbing layer 122 may cover the side surface of the first to third spacers 124a, 124b and 124c and fill a space between the first to third spacers 124a, 124b and 124c.

A thickness of the spacer 124 may be equal to or smaller than a distance between the driving electrode 132 and the first touch electrode 112. In an example embodiment of the present disclosure, the thickness of the spacer 124 may be smaller than the distance between the driving electrode 132 and the first touch electrode 112. When the thickness of the spacer 124 is smaller than the distance between the driving electrode 132 and the first touch electrode 112, the light absorbing layer 122 can cover an upper end of the spacer 124 in the second driving mode so that the transmittance of the transmittance variable touch panel 110 in the second driving mode can be minimized or reduced.

The partition wall 140 may have a thickness being equal to a distance between the first touch electrode 112 and the driving electrode 132. Namely, the thickness of the partition wall 140 may be equal to or greater than that of the spacer 124. In an example embodiment of the present disclosure, the thickness of the partition wall 140 may be greater than that of the spacer 124.

The second buffer layer 103 is disposed on the driving electrode 132 and the bridge electrode 188, and the color filter panel 150 is disposed on the second buffer layer 103.

The color filter panel 150 may include a black matrix 151 corresponding to the non-emission areas NEA1 and NEA2 and a color filter layer 154 corresponding to the emission areas EA1, EA2 and EA3.

The black matrix 151 may include a first black matrix 152 corresponding to the first non-emission area NEA1 and a second black matrix 153 corresponding to the second non-emission area NEA2. Each of the first and second black matrixes 152 and 153 may correspond to a boundary of the pixel region P.

A width of the black matrix 151 may be smaller than that of the bank 156. Namely, the bank 156 may have a first opening in correspondence to each of the emission areas EA1, EA2 and EA3, and the black matrix 151 may have a second opening in correspondence to each of the emission areas EA1, EA2 and EA3. In this case, a width (or an area) of the first opening may be smaller than that of the second opening.

A distance between adjacent spacers 124 may be equal to or smaller than a distance between adjacent black matrixes 151. Accordingly, in the first driving mode, the light absorbing layer 122 positioned at the lower side surface of the spacer 124 can be shielded by the black matrix 151 so that the display quality of the light emitting diode display device 100 can be improved by preventing the light absorbing layer 122 from being recognized.

A width of each of the first touch electrode 112 and the driving electrode 132 may be equal to or greater than that of the black matrix 151. In an example embodiment of the present disclosure, the width of each of the first touch electrode 112 and the driving electrode 132 may be greater than that of the black matrix 151. Accordingly, in the first driving mode, the light absorbing layer 122 positioned at an edge of the first touch electrode 112 can be shielded by the black matrix 151 so that the display quality of the light emitting diode display device 100 can be improved by preventing the light absorbing layer 122 from being recognized.

The color filter layer 154 is positioned between adjacent black matrixes 151. The color filter layer 154 may include a first color filter pattern 155 corresponding to the first emission area EA1, a second color filter pattern 156 corresponding to the second emission area EA2 and a third color filter pattern 157 corresponding to the third emission area EA3.

The first color filter pattern 155 may be a red color filter pattern and include a red dye or a red pigment. The second color filter pattern 156 may be a green color filter pattern and include a green dye or a green pigment. The third color filter pattern 157 may be a blue color filter pattern and include a blue dye or a blue pigment.

The color filter panel 150 may further include a protection layer 158 covering the black matrix 151 and the color filter layer 154. The protection layer 158 may be formed of an inorganic insulating material, e.g., silicon oxide or silicon nitride, or an organic insulating material, e.g., photo-acryl or benzocyclobutene.

The light emitting diode display device 100 according to the first embodiment of the present disclosure includes the transmittance variable touch panel 110 disposed over the display panel 101 and being capable of controlling a transmittance so that an ambient light reflection can be minimized or reduced without brightness degradation.

Namely, the light absorbing layer 122 in the first driving mode is positioned in the non-emission areas NEA1 and NEA2, and the light absorbing layer 122 in the second driving mode covers a side surface of the spacer 124 positioned in the first to third emission areas EA1, EA2 and EA3. Accordingly, the brightness of the first to third emission areas EA1, EA2 and EA3 in the first driving mode is not decreased, and the ambient light reflection of the first to third emission areas EA1, EA2 and EA3 in the second driving mode can be reduced.

In addition, since the light absorbing layer 122 can be driven by using the first touch electrode 112, an addition of additional elements for reducing the ambient light reflection can be minimized or reduced.

Moreover, when a thickness of the spacer 124 is smaller than a distance between the driving electrode 132 and the first touch electrode 112, the light absorbing layer 122 covers an upper end of the spacer 124 so that the ambient light reflection can be further reduced.

Furthermore, since the black matrix 151 has a width being greater than the first touch electrode 112, the light absorbing layer 122 at an edge of the first touch electrode 112 in the first driving mode can be shielded by the black matrix 151.

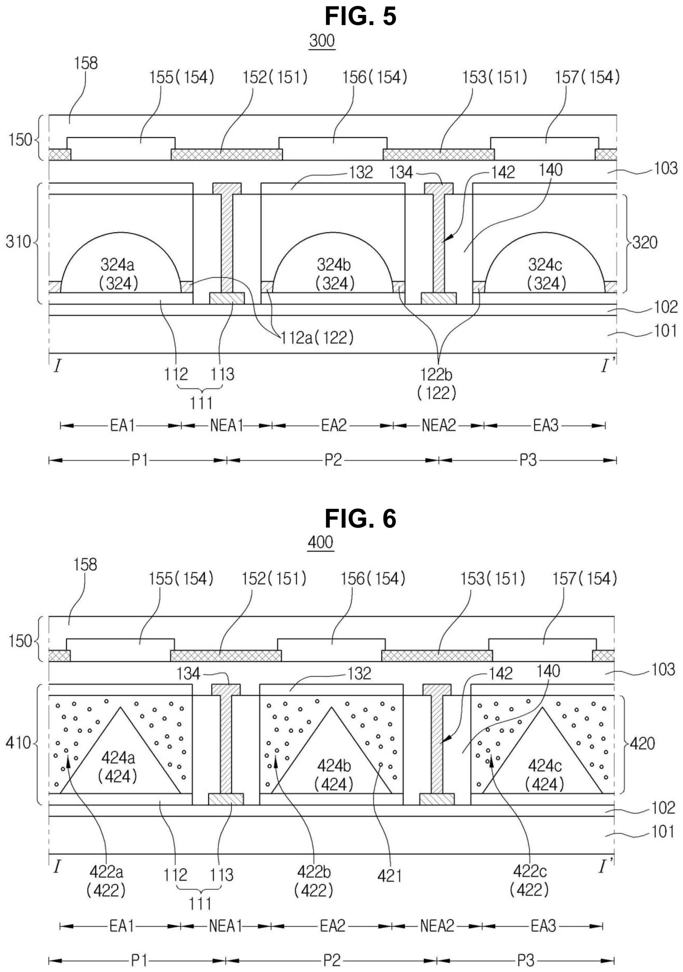

FIG. 5 is a schematic cross-section view illustrating the light emitting diode display device according to a second embodiment of the present disclosure.

As shown in FIG. 5, the light emitting diode display device 300 includes a display panel 101 and a transmittance variable touch panel 310 disposed over the display panel 101.

The display panel 101 may be an organic light emitting diode display panel or an inorganic light emitting diode display panel.

In addition, the light emitting diode display device 300 may further include a color filter panel 150 disposed over the transmittance variable touch panel 310. Namely, the transmittance variable touch panel 310 may be positioned between the display panel 101 and the color filer panel 150.

Moreover, the light emitting diode display device 300 may further include at least one of a first buffer layer 102 between the display panel 101 and the transmittance variable touch panel 310 and a second buffer layer 103 between the transmittance variable touch panel 310 and the color filter panel 150.

The light emitting diode display device 300 according to the second embodiment of the present disclosure has a difference in a configuration of a spacer 324 of the transmittance variable touch panel 310 from the light emitting diode display device 100 according to the first embodiment of the present disclosure. The description is focused on the spacer 324 of the transmittance variable touch panel 310.

The transmittance variable touch panel 310 includes a transmittance variable layer 320, a driving electrode 132 and a touch electrode layer 111. The transmittance variable layer 320 may include a spacer 324 and the light absorbing layer 122 positioned in each of the first to third pixel regions P1, P2 and P3.

The touch electrode layer 111 and the driving electrode 132 respectively positioned on one side and the other side of the transmittance variable layer 320. The first touch electrode 112 and the driving electrode 132 are positioned in each of the first to third emission areas EA1, EA2 and EA3, and the second touch electrode 113 is positioned in each of the first and second non-emission areas NEA1 and NEA2.

In addition, the transmittance variable touch panel 310 may further include a partition wall 140 in the first and second non-emission areas NEA1 and NEA2 and a bridge electrode 134 on the partition wall 140.

The spacer 324 includes a first spacer 324a in the first emission area EA1, a second spacer 324b in the second emission area EA2 and a third spacer 324c in the third emission area EA3.

Each of the first to third spacers 324a, 324b and 324c has a lower portion having a first width and an upper portion having a second width. The second width is smaller than the first width. For example, each of the first to third spacers 124a, 124b and 124c may have a dome shape (e.g., a lens shape). Accordingly, the light from the display panel 101 is concentrated so that the optical efficiency in the first to third emission areas EA1, EA2 and EA3 can be improved.

The light emitting diode display device 300 according to the second embodiment of the present disclosure includes the transmittance variable touch panel 310 disposed over the display panel 101 and being capable of controlling a transmittance so that an ambient light reflection can be minimized or reduced without brightness degradation.

Namely, the light absorbing layer 122 of the transmittance variable touch panel 310 in the first driving mode is positioned in the non-emission areas NEA1 and NEA2, and the light absorbing layer 122 of the transmittance variable touch panel 310 in the second driving mode covers a side surface of the spacer 324 positioned in the emission areas EA1, EA2 and EA3. Accordingly, the brightness of the emission areas EA1, EA2 and EA3 in the first driving mode is not decreased, and the ambient light reflection of the emission areas EA1, EA2 and EA3 in the second driving mode can be reduced.

In addition, since the light absorbing layer 122 can be driven by using the first touch electrode 112, an addition of additional elements for reducing the ambient light reflection can be minimized or reduced.

Moreover, when a thickness of the spacer 324 is smaller than a distance between the driving electrode 132 and the first touch electrode 112, the light absorbing layer 122 covers an upper end of the spacer 324 so that the ambient light reflection can be further reduced.

Further, since the spacer 324 has a dome shape (e.g., a lens shape), the light from the display panel 101 is concentrated so that the optical efficiency in the first to third emission areas EA1, EA2 and EA3 can be improved.

Furthermore, since the black matrix 151 has a width being greater than the first touch electrode 112, the light absorbing layer 122 at an edge of the first touch electrode 112 in the first driving mode can be shielded by the black matrix 151 so that the display quality of the light emitting diode display device 300 can be improved.

FIG. 6 is a schematic cross-section view illustrating the light emitting diode display device according to a third embodiment of the present disclosure.

As shown in FIG. 6, the light emitting diode display device 400 includes a display panel 101 and a transmittance variable touch panel 410 disposed over the display panel 101.

The display panel 101 may be an organic light emitting diode display panel or an inorganic light emitting diode display panel.

In addition, the light emitting diode display device 400 may further include a color filter panel 150 disposed over the transmittance variable touch panel 410. Namely, the transmittance variable touch panel 410 may be positioned between the display panel 101 and the color filer panel 150.

Moreover, the light emitting diode display device 400 may further include at least one of a first buffer layer 102 between the display panel 101 and the transmittance variable touch panel 410 and a second buffer layer 103 between the transmittance variable touch panel 410 and the color filter panel 150.

The light emitting diode display device 400 according to the third embodiment of the present disclosure has a difference in a configuration of a transmittance variable layer 420 of the transmittance variable touch panel 410 from the light emitting diode display device 100 according to the first embodiment of the present disclosure. The description is focused on the transmittance variable layer 420 of the transmittance variable touch panel 410.

The transmittance variable touch panel 410 includes a transmittance variable layer 420, a driving electrode 132 and a touch electrode layer 111. The transmittance variable layer 420 may include a spacer 324 and an electrochromic material layer 422 in the first to third pixel regions P1, P2 and P3.

The touch electrode layer 111 and the driving electrode 132 respectively positioned on one side and the other side of the transmittance variable layer 420. The first touch electrode 112 and the driving electrode 132 are positioned in each of the first to third emission areas EA1, EA2 and EA3, and the second touch electrode 113 is positioned in each of the first and second non-emission areas NEA1 and NEA2.

In addition, the transmittance variable touch panel 410 may further include a partition wall 140 in the first and second non-emission areas NEA1 and NEA2 and a bridge electrode 134 on the partition wall 140.

The electrochromic material layer 422 may include a first electrochromic material layer 422a in the first emission area EA1, a second electrochromic material layer 422b in the second emission area EA2 and a third electrochromic material layer 422c in the third emission area EA3. For example, a width of each of the first to third electrochromic material layers 422a, 422b and 422c may be equal to that of each of the first touch electrode 112 and the driving electrode 132.

In each of the first to third emission areas EA1, EA2 and EA3, each of the first to third electrochromic material layers 422a, 422b and 422c fills a space except the spacer 324.

Each of the first to third electrochromic material layers 422a, 422b and 422c includes an electrochromic particle 421. The electrochromic particle 421 is a material that change color depending on the applied voltage.

The electrochromic particle 421 may include at least one of a metal oxide, e.g., tungsten oxide, iridium oxide, nickel oxide or vanadium oxide, an organic material, e.g., viologen or quinone, and a conductive polymer, e.g., polythiophene, polyaniline, or polypyrrole. In an example embodiment of the present disclosure, the electrochromic particle 421 may have a core-shell structure including a core and a shell surrounding the core. The core may include at least one of an indium-tin oxide compound and a titanium oxide compound, and the shell may include at least one of viologen and quinone.

In a first driving mode, in which the light emitting diode D is on, no voltage difference occurs between the driving electrode 132 and the first touch electrode 112 so that the electrochromic particle 421 of the electrochromic material layer 422 is transparent.

As a result, in the first driving mode, the transmittance variable touch panel 410 or the light emitting diode display device 400 has a relatively high transmittance in each of the first to third emission areas EA1, EA2 and EA3. Accordingly, the light from the light emitting diode D of the display panel 101 can be displayed in the first to third emission areas EA1, EA2 and EA3 without brightness degradation.

In a second driving mode, in which the light emitting diode D is off, a voltage difference occurs between the driving electrode 132 and the first touch electrode 112 so that the light is absorbed by the electrochromic particle 421 of the electrochromic material layer 422.

As a result, in the first driving mode, the transmittance variable touch panel 410 or the light emitting diode display device 400 has a relatively low transmittance in each of the first to third emission areas EA1, EA2 and EA3. Accordingly, the ambient light reflection in the light emitting diode display device 400 can be minimized or reduced.

In the light emitting diode display device 400, a width of the electrochromic material layer 422 may be equal to that of the black matrix 151. The electrochromic material layer 422 in the first driving mode is transparent, it is not required that the black matrix 191 shields the electrochromic material layer 422. Accordingly, a width of the electrochromic material layer 422 can be increased, and the reduce of an area of the first to third emission areas EA1, EA2 and EA3 can be prevented or reduced. As a result, the light emitting diode display device 400 having high brightness and optical efficiency can be provided.

In FIG. 6, the spacer 424 has a triangular cone shape. Alternatively, the spacer 424 may have a dome shape.

The light emitting diode display device 400 according to the third embodiment of the present disclosure includes the transmittance variable touch panel 410 disposed over the display panel 101 and being capable of controlling a transmittance so that an ambient light reflection can be minimized or reduced without brightness degradation.

Namely, the electrochromic material layer 422 of the transmittance variable touch panel 310 in the first driving mode is positioned in the first to third emission areas EA1 and EA3 to have a first transmittance. The electrochromic material layer 422 of the transmittance variable touch panel 310 in the first driving mode is discolored to have a second transmittance being lower than the first transmittance. Accordingly, the brightness of the emission areas EA1, EA2 and EA3 in the first driving mode is not decreased, and the ambient light reflection of the emission areas EA1, EA2 and EA3 in the second driving mode can be reduced.

In addition, since the electrochromic material layer 422 can be driven by using the first touch electrode 112, an addition of additional elements for reducing the ambient light reflection can be minimized or reduced.

Moreover, when a thickness of the spacer 424 is smaller than a distance between the driving electrode 132 and the first touch electrode 112, the electrochromic material layer 422 covers an upper end of the spacer 424 so that the ambient light reflection can be further reduced.

Further, the black matrix 151 does not need to shield the electrochromic material layer 422, the reduce of the area of the first to third emission areas EA1, EA2 and EA3 so that the light emitting diode display device 400 having high brightness and optical efficiency can be provided.

Furthermore, when the spacer 424 has a dome shape (e.g., a lens shape), the light from the display panel 101 is concentrated so that the optical efficiency in the first to third emission areas EA1, EA2 and EA3 can be improved.

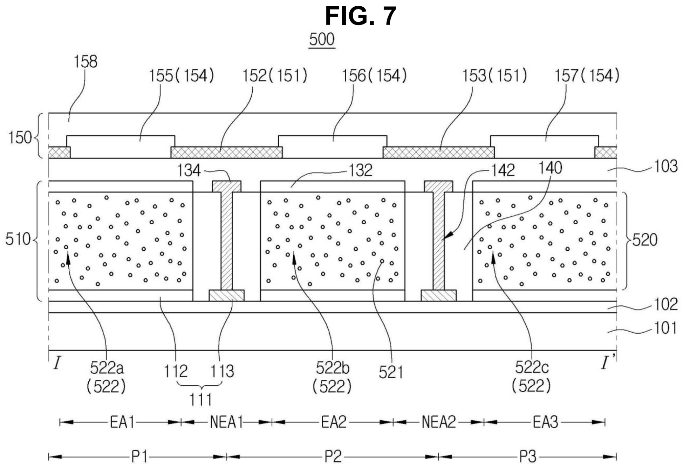

FIG. 7 is a schematic cross-section view of an organic light emitting display device according to a fourth embodiment of the present disclosure.

As shown in FIG. 7, the light emitting diode display device 500 includes a display panel 101 and a transmittance variable touch panel 510 disposed over the display panel 101.

The display panel 101 may be an organic light emitting diode display panel or an inorganic light emitting diode display panel.

In addition, the light emitting diode display device 500 may further include a color filter panel 150 disposed over the transmittance variable touch panel 510. Namely, the transmittance variable touch panel 510 may be positioned between the display panel 101 and the color filer panel 150.

Moreover, the light emitting diode display device 500 may further include at least one of a first buffer layer 102 between the display panel 101 and the transmittance variable touch panel 510 and a second buffer layer 103 between the transmittance variable touch panel 510 and the color filter panel 150.

The light emitting diode display device 500 according to the fourth embodiment of the present disclosure has a difference in a configuration of a transmittance variable layer 520 of the transmittance variable touch panel 510 from the light emitting diode display device 400 according to the third embodiment of the present disclosure. The description is focused on the transmittance variable layer 520 of the transmittance variable touch panel 510.

The transmittance variable touch panel 510 includes a transmittance variable layer 520, a driving electrode 132 and a touch electrode layer 111. The transmittance variable layer 520 may include an electrochromic material layer 522 in the first to third pixel regions P1, P2 and P3.

The electrochromic material layer 522 may include a first electrochromic material layer 522a in the first emission area EA1, a second electrochromic material layer 522b in the second emission area EA2 and a third electrochromic material layer 522c in the third emission area EA3. For example, a width of each of the first to third electrochromic material layers 522a, 522b and 522c may be equal to that of each of the first touch electrode 112 and the driving electrode 132. Each of the first to third electrochromic material layers 522a, 522b and 522c includes an electrochromic particle 521. The electrochromic particle 521 is a material that changes color depending on the applied voltage. The electrochromic particle 521 may be configured in a similar or the same manner as the electrochromic particle 421 described herein above. That is, one or more (e.g., all) embodiments described for the electrochromic particle 421 may equally be applied to the electrochromic particle 521.

The transmittance variable layer 420 of the light emitting diode display device 400 according to the third embodiment of the present disclosure includes the spacer 424 and the electrochromic material layer 422, while the transmittance variable layer 520 of the light emitting diode display device 500 according to the fourth embodiment of the present disclosure includes the electrochromic material layer 522 without a spacer.

Namely, the electrochromic material layer 522 may completely fill a space of each of the first to third emission areas EA1, EA2 and EA3. The electrochromic material layer 522 in each of the first to third emission areas EA1, EA2 and EA3 contacts an entire upper surface of the first touch electrode 112 and an entire lower surface of the driving electrode 132.

In the light emitting diode display device 400 according to the third embodiment of the present disclosure, the electrochromic material layer 422 has a first thickness at a lower portion of the spacer 424 and a second thickness, which is greater than the first thickness, at an upper portion of the spacer 424. Namely, the electrochromic material layer 422 has a thickness deviation at a center and an edge of each of the first to third emission areas EA1, EA2 and EA3 so that there may be a transmittance deviation at the center and the edge of each of the first to third emission areas EA1, EA2 and EA3 in the second driving mode.

However, in the light emitting diode display device 500 according to the fourth embodiment of the present disclosure, since the electrochromic material layer 522 has a constant thickness at the center and the edge of each of the first to third emission areas EA1, EA2 and EA3, a transmittance deviation at the center and the edge of each of the first to third emission areas EA1, EA2 and EA3 in the second driving mode can be prevented or reduced. Accordingly, the light emitting diode display device 500 has a uniform ambient light reflection prevention property and can effectively prevent or reduce defects, e.g., rainbow spots, caused by the ambient light reflection.

The light emitting diode display device 500 according to the third embodiment of the present disclosure includes the transmittance variable touch panel 510 disposed over the display panel 101 and being capable of controlling a transmittance so that an ambient light reflection can be minimized or reduced without brightness degradation.

Namely, the electrochromic material layer 522 of the transmittance variable touch panel 510 in the first driving mode is positioned in the first to third emission areas NEA1 and NEA2 to have a first transmittance. The electrochromic material layer 522 of the transmittance variable touch panel 510 in the first driving mode is discolored to have a second transmittance being lower than the first transmittance. Accordingly, the brightness of the emission areas EA1, EA2 and EA3 in the first driving mode is not decreased, and the ambient light reflection of the emission areas EA1, EA2 and EA3 in the second driving mode can be reduced.

Since the electrochromic material layer 522 has a constant thickness at the center and the edge of each of the first to third emission areas EA1, EA2 and EA3, the light emitting diode display device 500 has a uniform ambient light reflection prevention property and can effectively prevent or reduce defects, e.g., rainbow spots, caused by the ambient light reflection.

In addition, since the electrochromic material layer 522 can be driven by using the first touch electrode 112, an addition of additional elements for reducing the ambient light reflection can be minimized or reduced.

Further, the black matrix 151 does not need to shield the electrochromic material layer 522, the reduce of the area of the first to third emission areas EA1, EA2 and EA3 so that the light emitting diode display device 500 having high brightness and optical efficiency can be provided.

Various embodiments of the present disclosure provide a light emitting diode display device, comprising: a display panel; a first pixel region, a second pixel region, and a third pixel region; a light emitting diode in each of a first emission area of the first pixel region, a second emission area of the second pixel region, and a third emission area of the third pixel region; a transmittance variable layer disposed on the display panel and in each of the first emission area, the second emission area, and the third emission area; a touch electrode layer disposed at one side of the transmittance variable layer and including a first touch electrode and a second touch electrode, wherein the first touch electrode is disposed in each of the first emission area, the second emission area, and the third emission area, wherein the second touch electrode is disposed in each of a first non-emission area and a second non-emission area, and wherein the first non-emission area is between the first emission area and the second emission area, and the second non-emission area is between the second emission area and the third emission area; and a driving electrode disposed at another side of the transmittance variable layer, wherein the driving electrode corresponds to the first touch electrode.

In one or more embodiments, the light emitting diode display device further comprises: a spacer disposed in the transmittance variable layer, wherein the spacer corresponds to each of the first emission area, the second emission area, and the third emission area.

In one or more embodiments, a thickness of the spacer is smaller than a distance between the driving electrode and the first touch electrode.

In one or more embodiments, the spacer has a dome shape.

In one or more embodiments, the transmittance variable layer is a light absorbing layer including a charged black particle.

In one or more embodiments, the light emitting diode display device further comprises: a partition wall disposed in the first non-emission area and the second non-emission area, the partition wall separating the transmittance variable layer.

In one or more embodiments, the light emitting diode display device further comprises: a first black matrix and a second black matrix disposed over the transmittance variable layer, wherein the first black matrix and the second black matrix correspond respectively to the first non-emission area and the second non-emission area; and a first color filter pattern, a second color filter pattern and a third color filter pattern disposed over the transmittance variable layer, wherein the first color filter pattern, the second color filter pattern and the third color filter pattern correspond respectively to the first emission area, the second emission area, and the third emission area.

In one or more embodiments, a width of each of the first black matrix and the second black matrix is greater than a width of the partition wall.

In one or more embodiments, the transmittance variable layer includes an electrochromic particle.

In one or more embodiments, the light emitting diode display device further comprises: a partition wall disposed in the first non-emission area and the second non-emission area, wherein the partition wall separates the transmittance variable layer.

In one or more embodiments, the touch electrode layer is positioned between the display panel and the transmittance variable layer. In this case, the light emitting diode display device may further comprise: a bridge electrode disposed on the partition wall, wherein the bridge electrode is connected to the second touch electrode through a contact hole in the partition wall.

In one or more embodiments, the driving electrode is positioned between the display panel and the transmittance variable layer. In this case, the light emitting diode display device may further comprise: a bridge electrode disposed on the partition wall, wherein the second touch electrode is connected to the bridge electrode through a contact hole in the partition wall.

In one or more embodiments, in a first driving mode, the transmittance variable layer has a first transmittance in each of the first emission area, the second emission area, and the third emission area, in a second driving mode, the transmittance variable layer has a second transmittance in each of the first emission area, the second emission area, and the third emission area, and the second transmittance is smaller than the first transmittance.

In one or more embodiments, in the first driving mode, the light emitting diode is on, and in the second driving mode, the light emitting diode is off.

In one or more embodiments, the light emitting diode display device further comprises: a first black matrix and a second black matrix disposed over the transmittance variable layer, wherein the first black matrix and the second black matrix correspond respectively to the first non-emission area and the second non-emission area; and a first color filter pattern, a second color filter pattern and a third color filter pattern disposed over the transmittance variable layer, wherein the first color filter pattern, the second color filter pattern and the third color filter pattern correspond respectively to the first emission area, the second emission area, and the third emission area.

In one or more embodiments, the display panel further includes: a first bank in the first non-emission area; and a second bank in the second non-emission area.

In one or more embodiments, the first bank has a width greater than a width of the first black matrix, and the second bank has a width greater than a width of the second black matrix.

In one or more embodiments, the width of the first black matrix is greater than a width of the second touch electrode.

It will be apparent to those skilled in the art that various modifications and variations can be made in the embodiments of the present disclosure without departing from the technical idea or scope of the present disclosure. Thus, it is intended that the modifications and variations cover this disclosure provided they come within the scope of the appended claims and their equivalents.

## Claims

1. A light emitting diode display device (100, 300, 400, 500), comprising:
a display panel (101);
a first pixel region (P1), a second pixel region (P2), and a third pixel region (P3);
a light emitting diode (D) in each of a first emission area (EA1) of the first pixel region (P1), a second emission area (EA2) of the second pixel region (P2), and a third emission area (EA3) of the third pixel region (P3);
a transmittance variable layer (120, 320, 420, 520) disposed on the display panel (101) and in each of the first emission area (EA1), the second emission area (EA2), and the third emission area (EA3);
a touch electrode layer (111) disposed at one side of the transmittance variable layer (120, 320, 420, 520) and including a first touch electrode (112) and a second touch electrode (113), wherein the first touch electrode (112) is disposed in each of the first emission area (EA1), the second emission area (EA2), and the third emission area (EA3), wherein the second touch electrode (113) is disposed in each of a first non-emission area (NEA1) and a second non-emission area (NEA2), and wherein the first non-emission area (NEA1) is between the first emission area (EA1) and the second emission area (EA2), and the second non-emission area (NEA2) is between the second emission area (EA2) and the third emission area (EA3); and
a driving electrode (132) disposed at another side of the transmittance variable layer (120, 320, 420, 520), wherein the driving electrode (132) corresponds to the first touch electrode (112).

2. The light emitting diode display device (100, 300, 400) according to claim 1, further comprising:
a spacer (124, 324, 424) disposed in the transmittance variable layer (120, 320, 420, 520), wherein the spacer (124, 324, 424) corresponds to each of the first emission area (EA1), the second emission area (EA2), and the third emission area (EA3).

3. The light emitting diode display device (100, 300, 400) according to claim 2, wherein a thickness of the spacer (124, 324, 424) is smaller than a distance between the driving electrode (132) and the first touch electrode (112).

4. The light emitting diode display device (300) according to claim 2 or 3, wherein the spacer (124, 324, 424) has a dome shape.

5. The light emitting diode display device (100, 300) according to any of claims 2 to 4, wherein the transmittance variable layer (120, 320) is a light absorbing layer including a charged black particle.

6. The light emitting diode display device (100, 300) according to claim 5, further comprising:
a partition wall (140) disposed in the first non-emission area (NEA1) and the second non-emission area (NEA2), the partition wall (140) separating the transmittance variable layer (120, 320).

7. The light emitting diode display device (100, 300) according to claim 6, further comprising:
a first black matrix (152) and a second black matrix (153) disposed over the transmittance variable layer (120, 320), wherein the first black matrix (152) and the second black matrix (153) correspond respectively to the first non-emission area (NEA1) and the second non-emission area (NEA2); and
a first color filter pattern (155), a second color filter pattern (156) and a third color filter pattern (157) disposed over the transmittance variable layer (120, 320), wherein the first color filter pattern (155), the second color filter pattern (156) and the third color filter pattern (157) correspond respectively to the first emission area (EA1), the second emission area (EA2), and the third emission area (EA3).

8. The light emitting diode display device (100, 300) according to claim 7, wherein a width of each of the first black matrix (152) and the second black matrix (153) is greater than a width of the partition wall (140).

9. The light emitting diode display device (400, 500) according to any of claims 1 to 4, wherein the transmittance variable layer (420) includes an electrochromic particle (421, 521).

10. The light emitting diode display device (100, 300, 400, 500) according to any of claims 1 to 5, further comprising:
a partition wall (140) disposed in the first non-emission area (NEA1) and the second non-emission area (NEA2), wherein the partition wall (140) separates the transmittance variable layer (120, 320, 420, 520).

11. The light emitting diode display device (100, 300, 400, 500) according to claim 10, wherein the touch electrode layer (111) is positioned between the display panel (101) and the transmittance variable layer (120, 320, 420, 520),
the light emitting diode display device (100, 300, 400, 500), preferably, further comprising:
a bridge electrode (134) disposed on the partition wall (140), wherein the bridge electrode (134) is connected to the second touch electrode (113) through a contact hole (142) in the partition wall (140).

12. The light emitting diode display device according to claim 10, wherein the driving electrode (132) is positioned between the display panel (101) and the transmittance variable layer (120),
the light emitting diode display device, preferably, further comprising:
a bridge electrode (134) disposed on the partition wall (140),
wherein the second touch electrode (113) is connected to the bridge electrode (134) through a contact hole (142) in the partition wall (140).

13. The light emitting diode display device (100, 300, 400, 500) according to any of claims 1 to 12, wherein in a first driving mode, the transmittance variable layer (120) has a first transmittance in each of the first emission area (EA1), the second emission area (EA2), and the third emission area (EA3),
wherein in a second driving mode, the transmittance variable layer (120) has a second transmittance in each of the first emission area (EA1), the second emission area (EA2), and the third emission area (EA3), and
wherein the second transmittance is smaller than the first transmittance,
wherein preferably:
in the first driving mode, the light emitting diode (D) is on, and
in the second driving mode, the light emitting diode (D) is off.

14. The light emitting diode display device (100, 300, 400, 500) according to any of claims 1 to 6, further comprising:
a first black matrix (152) and a second black matrix (153) disposed over the transmittance variable layer (120, 320, 420, 520), wherein the first black matrix (152) and the second black matrix (153) correspond respectively to the first non-emission area (NEA1) and the second non-emission area (NEA2); and
a first color filter pattern (155), a second color filter pattern (156) and a third color filter pattern (157) disposed over the transmittance variable layer (120, 320, 420, 520), wherein the first color filter pattern (155), the second color filter pattern (156) and the third color filter pattern (157) correspond respectively to the first emission area (EA1), the second emission area (EA2), and the third emission area (EA3).

15. The light emitting diode display device (100, 300, 400, 500) according to claim 14, wherein the display panel (101) further includes:
a first bank in the first non-emission area (NEA1); and
a second bank in the second non-emission area (NEA2),
wherein, preferably, the first bank has a width greater than a width of the first black matrix (152), and the second bank has a width greater than a width of the second black matrix (153),
wherein, further preferably, the width of the first black matrix (152) is greater than a width of the second touch electrode (113).
